(19) Europäisches Patentamt
European Patent Office
Office européen des brevets

(11) **EP 3 550 696 B1**

(12) **EUROPÄISCHE PATENTSCHRIFT**

(45) Veröffentlichungstag und Bekanntmachung des Hinweises auf die Patenterteilung:
**25.11.2020 Patentblatt 2020/48**

(51) Int Cl.:
*H02J 7/00* *(2006.01)*        *G01R 31/36* *(2020.01)*

(21) Anmeldenummer: **19162694.4**

(22) Anmeldetag: **14.03.2019**

(54) **BATTERIESYSTEM FÜR EIN KRAFTFAHRZEUG UND KRAFTFAHRZEUG**

MOTOR VEHICLE AND BATTERY SYSTEM FOR A MOTOR VEHICLE

SYSTÈME DE BATTERIE POUR UN VÉHICULE AUTOMOBILE ET VÉHICULE AUTOMOBILE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.04.2018 DE 102018204971**

(43) Veröffentlichungstag der Anmeldung:
**09.10.2019 Patentblatt 2019/41**

(73) Patentinhaber: **VOLKSWAGEN AKTIENGESELLSCHAFT**
**38440 Wolfsburg (DE)**

(72) Erfinder:
• **Juhl, Jochen**
  **31702 Lüdersfeld (DE)**
• **Blumenthal, Stephan**
  **67125 Dannstadt-Schauernheim (DE)**

(56) Entgegenhaltungen:
WO-A1-2015/087488    DE-A1-102012 210 616
DE-A1-102012 211 086    DE-A1-102012 211 088
DE-A1-102014 116 986

**Beschreibung**

Die Erfindung betrifft ein Batteriesystem für ein Kraftfahrzeug, aufweisend mindestens ein Batteriemodul mit einer Anzahl von Batteriezellen und mit einem Zellencontroller zur Überwachung und Einstellung des Ladungszustands der Batteriezellen, und einen Batteriemanagementcontroller, welcher mit dem oder jedem Zellencontroller signaltechnisch gekoppelt ist, wobei der Zellencontroller einen Analog-Digital-Wandler aufweist, welcher mittels einer Filterschaltung an die Batteriezellen des Batteriemoduls geführt ist. Die Erfindung betrifft weiterhin ein Kraftfahrzeug mit einem solchen Batteriesystem.

In einem Kraftfahrzeug dient ein Bordnetze (Kraftfahrzeug-Bordnetz) der Versorgung von elektrischen Verbrauchern und Geräten mit einer Betriebsspannung des Bordnetzes (Bordnetzspannung). Bei einem elektrisch angetriebenen oder antreibbaren Kraftfahrzeug, wie beispielsweise einem Elektro- oder Hybridfahrzeug, ist zusätzlich zum Bordnetz ein Traktionsnetz als Hochvolt-Versorgung vorgesehen, welches die für den elektromotorischen Antrieb notwendige höhere elektrische Leistung bereitstellt. Derartige Bordnetze oder Traktionsnetze werden in der Regel mittels eines jeweiligen Energiespeichers, beispielsweise in Form eines elektrochemischen Batteriesystems der eingangs genannten Art, versorgt. Unter einem solchen Batteriesystem ist hierbei insbesondere eine sogenannte sekundäre Batterie (Sekundärbatterie) des Kraftfahrzeugs zu verstehen. Bei einer solchen (sekundären) Batterie ist eine umgesetzte (umgewandelte) chemische Energie mittels eines elektrischen Ladevorgangs (Aufladevorgangs) wiederherstellbar.

Derartige Batterien oder Batteriesysteme sind insbesondere als elektrochemische Akkumulatoren (Akku), beispielsweise als Lithium-Ionen-Akkumulatoren, ausgeführt, bei welchen eine Anzahl von einzelnen Batterie- oder Akkuzellen zu einem oder mehreren Batteriemodulen zusammengefasst sind.

Zum Zwecke eines sicheren und zuverlässigen Betriebs des Batteriesystems ist in der Regel ein Batteriemanagementsystem (BMS) vorgesehen. Dieses überwacht die Betriebsgrenzen des Batteriesystems und ergreift gegebenenfalls Maßnahmen, um Schäden am Batteriesystem und dessen Umgebung zu vermeiden. Über diese Sicherheitsfunktionen hinaus bestimmt das BMS Zustandsgrößen der Batteriemodule beziehungsweise der einzelnen Batteriezellen, wie beispielsweise deren aktuellen Ladezustand, die verfügbare Leistung und/oder den Alterungszustand. Ferner verfügt das BMS über unterschiedliche Kommunikationsschnittstellen, um beispielsweise Daten mit einem übergeordneten Kraftfahrzeugsystem auszutauschen.

Das BMS umfasst in der Regel einen Batteriemanagementcontroller (BMC, Battery Pack Controller) und eine Anzahl von den Batteriemodulen zugeordneten Zellencontrollern (Cell Controller), welche beispielsweise mittels eines CAN-Busses (Central Area Network) miteinander signaltechnisch gekoppelt sind. Im Normalbetrieb des Batteriesystems werden die Betriebszustände der einzelnen Batteriemodule oder Batteriezellen mittels des jeweils zugeordneten Zellencontrollers im Zuge eines Einzel-Zellen-Managements überwacht, und die entsprechenden Messdaten werden von den Zellencontrollern an den Batteriemanagementcontroller übertragen. Die Zellencontroller sind hierbei im Zuge des Einzel-Zellen-Managements insbesondere zum Ladungsausgleich (Balancing) zwischen einzelnen Batteriezellen eingerichtet, dies bedeutet, dass die Zellencontroller eine Ausgleichstufe oder Balancingstufe aufweisen, mittels welcher Ladungsunterschiede zwischen einzelnen Batteriezellen ausgleichbar sind.

Die Zellencontroller weisen zur Überwachung der Batteriezellen jeweils eine Zellspannungsmesseinrichtung mit mindestens einen Analog-Digital-Wandler auf, welcher die (Batterie-)Zellenspannungen der Batteriezellen mittels einer Abtastfrequenz abtastet und in ein digitales (Mess-)Signal wandelt. Zur Einhaltung des Nyquist-Shannon-Abtasttheorems ist den Eingangsanschlüssen der Analog-Digital-Wandler der Zellencontroller häufig eine Filterschaltung, insbesondere ein Tiefpassfilter, vorgeschaltet. Dies bedeutet, dass eine Grenzfrequenz der Filterschaltung vorzugsweise kleiner oder gleich der halben Abtastfrequenz des Analog-Digital-Wandlers ist. Ein derartiges Batteriesystem ist beispielsweise aus der DE 10 2012 211 086 A1 und der DE 10 2012 211 088 A1 bekannt.

Gemäß dem Nyquist-Shannon-Abtasttheorems kann ein mit einer Maximalfrequenz bandbegrenztes Signal aus einer Folge von äquidistanten Abtastwerten exakt rekonstruiert werden, wenn es mit einer Abtastfrequenz abgetastet wurde, welche mindestens doppelt so groß ist wie die Maximalfrequenz des Signals.

Das BMS steuert und/oder regelt sowie überwacht das Batteriesystem im Betrieb, vorzugsweise während eines Lade- oder Entladevorgangs. Insbesondere wird hierbei mittels der Zellencontroller der Ladezustand (State of Charge, SOC) auf der Einzel-Zellen- und Systemebene überwacht. Unter Verwendung weiterer Sensorik werden die Batterieströme, die Batteriespannungen und die Batterietemperaturen der Batteriezellen und des Gesamtsystems gemessen und geregelt. Der Batteriemanagementcontroller ermöglicht hierbei insbesondere eine Fehlererfassung oder Fehlerprotokollierung sowie das Zu- und Abschalten des Batteriesystems.

Insbesondere bei elektrisch angetriebenen oder antreibbaren Kraftfahrzeugen, wie beispielsweise Elektro- oder Hybridfahrzeugen, ist das Batteriesystem ein emissionsrelevantes System des Kraftfahrzugs. Daher ist es wünschenswert, dass das Batteriesystem die Anforderungen der OBD (On-Board-Diagnose), insbesondere der sogenannten OBD2, erfüllt. Dies bedeutet, dass im Fahrbetrieb der Betriebszustand des Batteriesystems, insbesondere jedes Batteriemoduls oder jeder Batteriezelle, überwacht wird, und auftretende Fehler in einem Fehlerspeicher eines (Kraftfahrzeug-)Steuergeräts abgelegt werden. Mit anderen Worten erfolgt periodisch oder regelmäßig eine Diagnose oder Abfrage der Betriebszustände aller Batteriemodule. Insbesondere wird nach der OBD2 gefordert, dass periodisch nach Ablauf von 500 ms (Millisekunden) eine Diagnose aller Sensoren und Aktoren des Batteriesystems erfolgen muss.

Zur Kostenreduzierung des Batteriesystems ist es wünschenswert, dass die Anzahl der CAN-Knoten des BMSs reduziert wird. Gleichzeitig soll das BMS, und somit die Zellencontroller, weiterhin die OBD2 erfüllen. Hierzu werden häufig batteriesysteminterne Schnittstellen zur Signalkommunikation zwischen den Zellencontrollern genutzt, wodurch die Anzahl der CAN-Knoten reduziert werden soll. Nachteiligerweise wird hierdurch eine Beschränkung der maximal übertragbaren Messwerte bewirkt. Dies wirkt sich in der Folge negativ auf eine mögliche Abtastrate beziehungsweise auf die Abtastfrequenzen der einzelnen Zellenspannungen aus.

Die Grenzfrequenz der Filterschaltung hat einen direkten Einfluss auf die notwendige Diagnosezeit im Zuge der OBD2, also diejenige Zeitdauer zur Diagnose der Zellspannungsmesseinrichtungen beziehungsweise der Balancingstufen. Da während einer solchen Diagnose keine Messwerte für den Normalbetrieb des Batteriesystems, insbesondere hinsichtlich des Einzel-Zellen-Managements der Zellencontroller, erfasst werden, ist eine möglichst geringe Diagnosezeit gewünscht. Dies entspricht einer möglichst hohen Grenzfrequenz der Filterschaltungen. Andererseits ist im Normalbetrieb eine vergleichsweise niedrige Grenzfrequenz der Filterschaltungen gewünscht, um möglichst eine optimale und fehlerfreie Abtastung der Zellenspannungen mittels der Analog-Digital-Wandler zu gewährleistet.

Somit liegt eine Austauschbeziehung zwischen einer möglichst niedrigen Grenzfrequenz der Filterschaltung für den Normalbetrieb einerseits und einer möglichst hohen Grenzfrequenz der Filterschaltung für den Diagnosebetrieb des Batteriesystems andererseits vor. Zur Vermeidung dieser Austauschbeziehung ist es beispielsweise denkbar, eine direkte Kommunikation zwischen jedem einzelnen Zellencontroller und dem Batteriemanagementcontroller vorzusehen, sodass keine Begrenzung aufgrund der Schnittstellenübertragung auftritt. Dadurch würde jedoch die Anzahl der CAN-Knoten und der benötigte Bauraumbedarf sowie die Herstellungs- und Montagekosten nachteilig erhöht.

Alternativ sind ebenso redundante Messsysteme denkbar, welche lediglich für die Diagnose vorgesehen sind. Diese bewirken jedoch ebenfalls eine nachteilige Erhöhung des Bauraumbedarfs sowie der Herstellungskosten. Weiterhin ist es denkbar, ein Batteriesystem zu verwenden, welches entweder die Anforderungen des Abtasttheorems oder der OBD2 zumindest teilweise verletzt. Dadurch werden jedoch zusätzliche Messfehler bewirkt und/oder ein Batteriesystem in Kauf genommen, welches nicht uneingeschränkt in Elektro- oder Hybridfahrzeugen einsetzbar oder verwertbar ist.

In der DE 101 43 732 A1 ist eine Messsignal-Generatorschaltung für ein Bewegungsmessgerät mit einer linearen Skala beschrieben. Die Messsignal-Generatorschaltung weist eine Tiefpassschaltung in Form eines aktiven Filters auf, dessen Grenzfrequenz in Abhängigkeit der Bewegungsgeschwindigkeit variiert wird. Hierzu weist die Tiefpassschaltung eine geschaltete Kapazität für eine Zeitkonstantenschaltung auf, welche mittels eines bewegungsgeschwindigkeitsabhängigen Taktsignals angesteuert wird.

Aus der DE 693 18 787 T2 ist eine Wiegeeinrichtung zum Wiegen einer zu wiegenden Last zur Bereitstellung eines digitalen Wiegesignals bekannt. Die Wiegeeinrichtung weist einen Gewichtsdetektor zur Erzeugung eines analogen Wiegesignals auf. Das analoge Wiegesignal wird mittels einer Filterschaltung mit einer ersten Grenzfrequenz gefiltert und einem Analog-Digital-Wandler zugeführt, welcher das analoge Wiegesignal in das digitale Wiegesignal wandelt. Das digitale Wiegesignal wird anschließend mit einem digitalen Filter mit einer zweiten Grenzfrequenz, welche höher als die erste Grenzfrequenz ist, gefiltert.

Die DE 691 18 469 T2 offenbart eine Phasenregelschleifenschaltung mit einem Schleifenfilter mit einer Frequenzregelschaltung zur Einstellung und/oder Regelung der Grenzfrequenz des Schleifenfilters. Der bekannte Schleifenfilter weist entlang der Schleifenrichtung einen ersten ohmschen Widerstand auf. Diesem ersten Widerstand ist ein Knotenpunkt nachgeschaltet, welcher einen gegen Masse geschalteten Strompfad aufweist. In dem Strompfad sind knotenseitig ein zweiter ohmscher Widerstand und masseseitig ein erster Kondensator geschaltet. Parallel zu dem ersten Kondensator ist die Frequenzregelschaltung geschaltet, welche eine Reihenschaltung eines analogen Schaltelements und eines zweiten, gegen Masse geschalteten Kondensators aufweist.

In der WO 2015/087488 A1 ist eine Stromversorgung zur Ladung einer Fahrzeugbatterie aus einem externen Stromnetz bekannt. Die Fahrzeugbatterie weist einen Messwiderstand mit einer zugeordneten Strommesseinheit zur Erfassung eines Batteriestroms auf. Die Strommesseinheit weist einen einstellbaren Tiefpassfilter auf, dessen Grenzfrequenz zwischen zwei unterschiedlichen Frequenzwerten umschaltbar ist, wobei auf die niedrigere Grenzfrequenz geschaltet wird, wenn die Fahrzeugbatterie aus dem externen Stromnetz geladen wird.

Die DE 10 2014 116 986 A1 beschreibt ein Batteriesystem mit einer Ladungsausgleichsschaltung mit einer aktiven Abgleichschaltung. Das Batteriesystem weist eine Batterie mit einer Reihenschaltung von Batteriezellen auf. Die Abgleichschaltung kann so konfiguriert sein, dass Spannungen der Batteriezellen abgeglichen werden, indem Ladungen induktiv zwischen einer jeweiligen Batteriezelle und der Batterie mithilfe von Spannungsimpulsen übertragen werden.

Der Erfindung liegt die Aufgabe zugrunde, ein besonders geeignetes Batteriesystem für ein Kraftfahrzeug anzugeben. Insbesondere soll ein Batteriesystem angegeben werden, welches einerseits die Anforderungen des Abtasttheorems und andererseits die Anforderungen einer On-Board-Diagnose des Kraftfahrzeugs erfüllt. Der Erfindung liegt weiterhin die Aufgabe zugrunde, ein Kraftfahrzeug mit einem derartigen Batteriesystem anzugeben.

Hinsichtlich des Batteriesystems wird die Aufgabe mit den Merkmalen des Anspruchs 1 und hinsichtlich des Kraftfahrzeugs mit den Merkmalen des Anspruchs 8 erfindungsgemäß gelöst. Vorteilhafte Ausgestaltungen und Weiterbildungen sind Gegenstand der jeweiligen Unteransprüche.

Das erfindungsgemäße Batteriesystem ist für ein Kraftfahrzeug geeignet und eingerichtet. Das Batteriesystem ist hierbei insbesondere als ein elektrochemischer Energiespeicher für ein Kraftfahrzeug-Traktionsnetz ausgeführt. Insbesondere ist das Batteriesystem als ein Hochvolt-Spannungsversorgungssystem eines Elektro- oder Hybridfahrzeugs ausgeführt.

Das Batteriesystem weist mindestens ein Batteriemodul mit einer Anzahl von Batteriezellen und mit einem Zellencontroller (Cell Controller) zur Batteriezellenüberwachung auf. Der Zellencontroller ist hierbei für ein Einzel-Zellen-Management, also insbesondere zur Überwachung und Einstellung und/oder Regelung des Ladungszustands der Batteriezellen, vorgesehen. Das Batteriesystem weist weiterhin einen Batteriemanagementcontroller auf, welcher mit dem oder jedem Zellencontroller signaltechnisch gekoppelt ist. Der Batteriemanagementcontroller und der oder jeder Zellencontroller bilden ein Batteriemanagementsystem (BMS) des Batteriesystems.

Jeder Zellencontroller weist mindestens einen Analog-Digital-Wandler auf, mittels welchen analoge Spannungssignale der Batteriezellen, nachfolgend auch als Zellenspannung bezeichnet, in digitale Messsignale gewandelt werden. Die Analog-Digital-Wandler sind hierbei mittels einer jeweiligen Filterschaltung an die Batteriezellen des Batteriemoduls geführt. Die Filterschaltung ist hierbei beispielsweise in den Zellencontroller integriert oder diesem batteriezellenseitig vorgeschaltet.

Das Batteriesystem weist erfindungsgemäß eine Frequenzschaltung zur Einstellung einer Grenzfrequenz der Filterschaltung auf. Insbesondere ist die Frequenzschaltung hierbei vorzugsweise Teil einer jeweiligen Filterschaltung. Mittels der Frequenzschaltung ist die Grenzfrequenz der Filterschaltung während einer Abtastzeitdauer, bei welcher der Zellencontroller die Batteriezellen überwacht, also die Zellenspannung mittels einer Abtastfrequenz von dem Analog-Digital-Wandler abgetastet und digitalisiert wird, auf einen ersten Frequenzwert und während einer Diagnosezeitdauer, bei welcher der Batteriemanagementcontroller die Batteriezellen überwacht, also deren Betriebszustand, insbesondere den Betriebszustand der zugeordneten Sensoren und Aktoren der Batteriezellen, erfasst, auf einen zweiten Frequenzwert eingestellt. Dadurch ist ein besonders geeignetes Batteriesystem realisiert.

Die Abtastzeitdauer bezeichnet hierbei insbesondere einen Normalbetrieb des Batteriesystems, bei welchen die Betriebszustände der Batteriezellen von den jeweiligen Zellencontrollern des Batteriemoduls im Zuge eines Einzel-Zellen-Managements erfasst und überwacht werden. Die Diagnosezeitdauer bezeichnet insbesondere eine Zeitdauer im Zuge eines Diagnosebetriebs des Batteriesystems, bei welchem die Betriebszustände der Batteriezellen von dem Batteriemanagementcontroller hinsichtlich einer Fehlerprotokollierung erfasst und überwacht werden. Die Diagnosezeitdauer wird hierbei im Betrieb des Batteriesystems vorzugsweise regelmäßig, insbesondere im Zuge einer OBD (On Board Diagnose), vorzugsweise im Zuge einer OBD2, ausgelöst. Mit anderen Worten entspricht die Abtastzeitdauer im Wesentlichen der Zeitdauer zwischen zwei aufeinanderfolgenden Diagnosezeitdauern, also derjenigen Zeitdauer, für welche das Einzel-Zellen-Management der Zellencontroller unterbrochen oder pausiert wird. Bei einer OBD2 erfolgt die Auslösung einer Diagnosezeitdauer vorzugsweise spätestens nach 500 ms (Millisekunden). Dies bedeutet, dass die Abtastzeitdauern im Betrieb des Batteriesystems insbesondere kleiner gleich 500 ms sind.

Der erste Frequenzwert während der Abtastzeitdauer ist hierbei vorzugsweise derart gewählt, dass er das Abtasttheorem für den der Filterschaltung nachgeschalteten Analog-Digital-Wandlers erfüllt. Mit anderen Worten ist der erste Frequenzwert vorzugsweise kleiner oder gleich der halben Abtastfrequenz des Analog-Digital-Wandlers. Der zweite Frequenzwert während der Diagnosezeitdauer ist insbesondere dahingehend gewählt, dass eine möglichst kurze Diagnosezeitdauer realisiert ist. Mit anderen Worten ist der zweite Frequenzwert insbesondere höherfrequenter als der erste Frequenzwert.

Die Filterschaltung ist somit als ein analoges, aktives Filter ausgeführt, dessen Grenzfrequenz mittels der Frequenzschaltung einstellbar ist. Insbesondere wird die Filterschaltung während der Abtastzeitdauer auf eine vergleichsweise niedrige Grenzfrequenz eingestellt, sodass eine möglichst zuverlässige und betriebssichere, möglichst optimale Abtastung der Zellenspannungen gewährleistet ist. Im Zuge einer Diagnose, insbesondere einer OBD2, wird die Filterschaltung regelmäßig für eine Diagnosezeitdauer auf eine vergleichsweise hohe Grenzfrequenz eingestellt, wodurch eine besonders effektive und zeitsparende Diagnose und Fehlerprotokollierung ermöglicht ist.

Vorteilhafterweise ist somit ein Batteriesystem für ein Kraftfahrzeug realisiert, welches sowohl den Anforderungen des Abtasttheorems als auch der OBD2 genügt. Im Normalbetrieb des Batteriesystems werden die Zellenspannungen der Batteriezellen des oder jedes Batteriemoduls mittels des BMS gemäß den Anforderungen des Abtasttheorems zuverlässig und betriebssicher erfasst. Während des Diagnosebetriebs werden die Grenzfrequenzen der Filterschaltungen für die Diagnosezeitdauer kurzzeitig erhöht, so dass die aktuellen Betriebszustände in einer möglichst kurzen Zeitdauer von dem Batteriemanagementcontroller erfasst werden. Dadurch wird die Zeitdauer, während welcher keine Messung der Zellenspannungen seitens der Zellencontroller erfolgt, vorteilhaft reduziert. Somit ist ein besonders zuverlässiger und betriebssicherer Betrieb des Batteriesystems gewährleistet.

Die Filterschaltung ist beispielsweise als ein Hochpass, Tiefpass, Bandsperre oder Bandpass ausführbar, wobei bei einer Bandsperre oder einem Bandpass die obere und/oder untere Grenzfrequenz mittels der Frequenzschaltung einstellbar ist.

Unter dem Begriff "Grenzfrequenz" ist insbesondere eine Übergangs- oder Eckfrequenz (engl.: cutoff frequency) zu verstehen, also derjenige Frequenzwert, bei dessen Überschreitung eine eingangsseitige Signalamplitude am Ausgang der Filterschaltung um einen bestimmten Wert reduziert wird. Bei einem Hoch- oder Tiefpass mit einem maximalen (Spannungs-)Übertragungsfaktor von 1, wird die übertragende Amplitude bei der Grenzfrequenz auf einen $1/\sqrt{2}$ reduzierten Wert abgesenkt. Insbesondere tritt bei der Grenzfrequenz eine Phasenverschiebung von 45° zwischen dem Eingangs- und dem Ausgangssignal auf.

Durch das zeitweise Umschalten der Grenzfrequenz der Filterschaltung ist ein für (elektro-)automobile Anwendungen besonders geeignetes Batteriesystem gebildet.

Das BMS, also der Batteriemanagementcontroller und der oder jeder Zellencontroller, ist allgemein programm- und/oder schaltungstechnisch zur Durchführung des vorstehend beschriebenen Umschaltens der Grenzfrequenzen geeignet und eingerichtet. Das BMS ist somit konkret dazu eingerichtet, die Frequenzschaltung während der Abtastzeitdauer derart anzusteuern, dass der erste Frequenzwert für die Grenzfrequenz der Filterschaltung bewirkt wird, und dass bei einer Auslösung oder Bewirkung der Diagnosezeitdauer die Grenzfrequenz auf den zweiten Frequenzwert eingestellt (umgeschaltet, verändert) wird.

In bevorzugter Ausgestaltung sind der Batteriemanagementcontroller und/oder der Zellencontroller zumindest im Kern durch einen Microcontroller mit einem Prozessor und mit einem Datenspeicher gebildet, in dem die Funktionalität zur Durchführung des erfindungsgemäßen Umschaltens in Form einer Betriebssoftware (Firmware) programmtechnisch implementiert ist, sodass das Verfahren - gegebenenfalls in Interaktion mit einem Kraftfahrzeugnutzer - bei Ausführung der Betriebssoftware in dem Microcontroller automatisch durchgeführt wird.

Der Batteriemanagementcontroller und/oder der Zellencontroller kann im Rahmen der Erfindung alternativ aber auch durch ein nicht programmierbares elektronisches Bauteil, z.B. einen anwendungsspezifischen Schaltkreis (ASIC), gebildet sein, in dem die Funktionalität zur Durchführung des Umschaltens mit schaltungstechnischen Mitteln implementiert ist.

Vorzugsweise ist der Batteriemanagementcontroller als ein Mikrocontroller und der oder jeder Zellencontroller zumindest teilweise als ein ASIC ausgeführt.

In einer bevorzugten Ausführung weist das Batteriesystem mehrere Batteriemodule auf, welche in Reihe oder Serie und auch parallel geschaltet oder schaltbar sind. Die Zellencontroller der mehreren Batteriemodule sind hierbei mittels einer Busleitung nach Art einer Daisy-Chain an den Batteriemanagementcontroller geführt. Vorzugsweise wird die Daisy-Chain zwischen den Zellencontrollern mittels in die Zellencontroller integrierten Schnittstellen realisiert, wodurch CAN-Schnittstellen des Batteriesystems vorteilhaft reduziert werden. Mit anderen Worten wird die Busleitung im Wesentlichen mittels internen Schnittstellen der Zellencontroller gebildet. Dadurch ist ein besonders bauraumkompaktes und leitungsreduziertes Batteriesystem realisiert. Durch die einstellbaren Grenzfrequenzen ist hierbei stets eine zuverlässige und effektive Datenübertragung entlang der Busleitung, insbesondere im Zuge einer Diagnose des Batteriesystems, realisiert.

Vorzugsweise ist somit die Kommunikation somit mittels des Zellencontroller eigenen Kommunikationsbuses (TPL, ISO-SPI, ...) realisiert. Alternativ ist es beispielsweise ebenso denkbar, dass die Kommunikation der Zellencontroller auf ein standardisiertes Bussystem, insbesondere CAN, gewandelt wird, wobei die Zellencontroller hierbei vorzugsweise mit einem Niedrigspannungs-Versorgungssystem gekoppelt ist.

In einer zweckmäßigen Weiterbildung ist die Filterschaltung mittels der Frequenzschaltung reversibel zwischen den Frequenzwerten umschaltbar. Dadurch ist ein besonders geeignetes Batteriesystem realisiert.

In einer besonders vorteilhaften Ausführung ist die Filterschaltung als ein Tiefpass ausgeführt. Dadurch wird die Einhaltung des Abtasttheorems, insbesondere während der Abtastzeitdauer, sichergestellt.

In einer geeigneten Ausgestaltung weist die Filterschaltung einen mit den Batteriezellen und mit dem Analog-Digital-Wandler in Reihe geschalteten ohmschen Widerstand sowie einen parallel zu den Batteriezellen und dem Analog-Digital-Wandler geschalteten ersten Kondensator auf. Mit anderen Worten ist die Filterschaltung insbesondere als ein RC-Tiefpass (RC-Glied) ausgeführt. Dadurch ist eine besonders kostengünstige und bauteilreduzierte Filterschaltung realisiert.

In einer möglichen Ausführung der Filterschaltung ist die Frequenzschaltung einem Filterelement (Kondensator, Widerstand, Spule) der Filterschaltung parallel geschaltet. Die Frequenzschaltung weist hierbei geeigneterweise ein zweites Filterelement der gleichen Sorte wie das Filterelement der Filterschaltung auf. Bei einer Betätigung der Frequenzschaltung werden die beiden Filterelemente einander parallel geschalten, sodass sich der effektiv wirkende Filterwert (Kapazität, Widerstand, Induktivität) ändert und somit die Grenzfrequenz eingestellt wird. Insbesondere ist die Filterschaltung parallel zu dem ersten Kondensator des RC-Glieds geschaltet.

In einer geeigneten Weiterbildung weist die Frequenzschaltung hierbei ein betätigbares Schaltelement und einen zweiten Kondensator auf, welcher in Reihe zu dem Schaltelement geschaltet ist. Dadurch ist eine besonders flexible und effektive Filterschaltung realisiert.

Das Schaltelement ist beispielsweise als ein elektromechanisches Relais oder vorzugsweise als ein elektronisch schaltbarer Bipolar- oder Feldeffekttransistor ausgeführt. Durch die Frequenzschaltung ist der zweite Kondensator parallel zu dem ersten Kondensator schaltbar, wodurch bei einem Schließen des Schaltelements eine Parallelschaltung von Kapazitäten realisiert ist. Dadurch addieren sich die Kapazitätswerte der ersten und zweiten Kapazität zu einem effektiven Gesamtwert, wodurch die Filterschaltung effektiv eine reduzierte Grenzfrequenz aufweist.

Mit anderen Worten ist das Schaltelement während der Abtastzeitdauer geschlossen, also leitend geschaltet, sodass die Grenzfrequenz auf den ersten Frequenzwert erniedrigt oder reduziert wird. Während der Diagnosezeitdauer wird das Schaltelement geöffnet, also elektrisch nicht-leitend oder sperrend geschaltet, sodass lediglich die erste Kapazität wirkt und die Grenzfrequenz der Filterschaltung dem zweiten Frequenzwert entspricht.

In einer alternativen Ausführungsform ist die Frequenzschaltung beispielsweise als eine Reihenschaltung eines zweiten ohmschen Widerstands und des Schaltelements ausgeführt, welche dem ersten Widerstand des RC-Tiefpasses parallel geschaltet ist. Dadurch addieren sich bei einem geschlossenen Schaltelement die Leitwerte der ohmschen Widerstände. Dies bedeutet, dass der wirkende oder effektive Widerstandswert geringer als der geringste Widerstandswert der beiden Widerstände ist. Sind die Widerstände gleich dimensioniert so wirkt effektiv der halbe Widerstandswert. Dadurch wird die Grenzfrequenz erhöht. In dieser Ausführungsform ist das Schaltelement während der Abtastzeitdauer geschlossen und während der Diagnosezeitdauer geöffnet.

In einer bevorzugten Anwendung ist das Batteriesystem in einem Kraftfahrzeug eingebaut. Dies bedeutet, dass das Kraftfahrzeug ein vorstehend beschriebenes Batteriesystem aufweist. Bei dem Kraftfahrzeug handelt es sich insbesondere um ein elektrisch angetriebenes oder antreibbares Fahrzeug, vorzugsweise um ein Elektro- oder Hybridfahrzeug. Das Batteriesystem ist hierbei Teil eines Kraftfahrzeug-Traktionsnetzes und insbesondere als ein Hochvolt-Spannungsversorgungssystem ausgebildet. Durch das erfindungsgemäße Umschalten der Grenzfrequenzen der Filterschaltungen im Zuge einer (Fahrzeug-)Diagnose oder OBD, ist ein besonders geeigneter und betriebssicherer Betrieb des Batteriesystems gewährleistet, welcher sich vorteilhaft auf den Betrieb des Kraftfahrzeugs überträgt. Dadurch ist ein besonders geeignetes Kraftfahrzeug realisiert.

Nachfolgend sind Ausführungsbeispiele der Erfindung anhand einer Zeichnung näher erläutert. Darin zeigen in vereinfachten Darstellungen:

Fig. 1    schematisch ein Kraftfahrzeug mit einem Batteriesystem als Blockschaltbild,

Fig. 2    schematisch in einem Blockschaltbild ein Batteriemodul des Batteriesystems,

Fig. 3    eine Filterschaltung des Batteriesystems gemäß einer ersten Ausführungsform, und

Fig. 4    die Filterschaltung des Batteriesystems gemäß einer zweiten Ausführungsform.

Einander entsprechende Teile und Größen sind in allen Figuren stets mit den gleichen Bezugszeichen versehen.

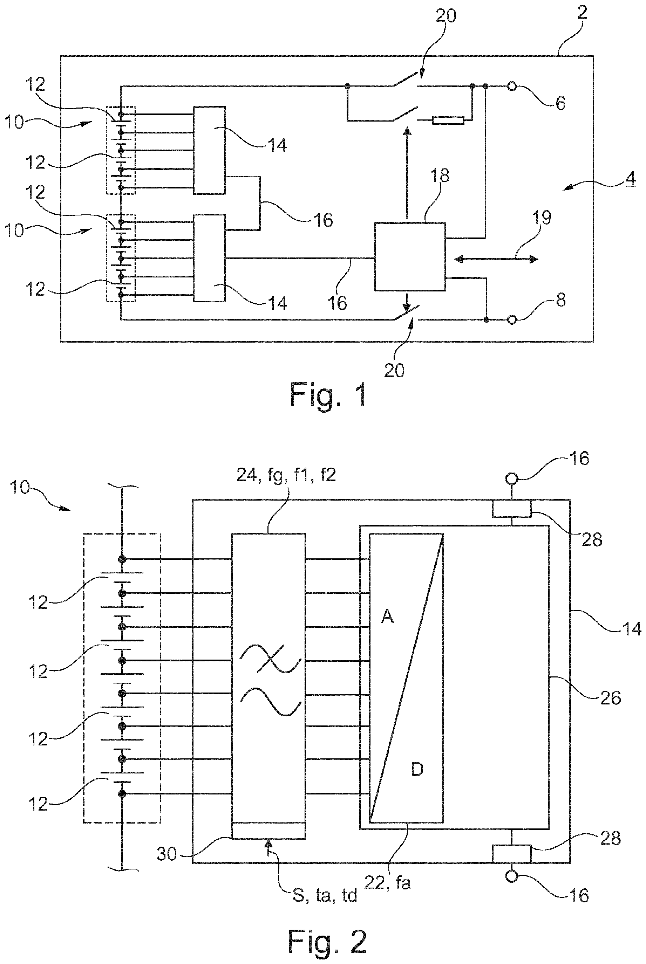

Das in der Fig. 1 lediglich stark vereinfacht dargestellte Kraftfahrzeug 2 weist ein Batteriesystem 4 auf. Das Kraftfahrzeug 2 ist in diesem Ausführungsbeispiel insbesondere ein Elektro- oder Hybridfahrzeug, wobei das Batteriesystem 4 insbesondere als ein Hochvolt-Spannungsversorgungssystem zum Betrieb eines nicht näher dargestellten elektromotorischen Antriebsmotors ausgebildet ist. Das Batteriesystem 4 ist als elektrischer oder elektrochemischer Energiespeicher Teil eines Kraftfahrzeug-Traktionsnetzes. Das Batteriesystem 4 kann mittels zweier Anschlüsse 6, 8 an einen nicht näher gezeigten Zwischenkreis des Kraftfahrzeugs 2 angeschlossen sein.

Das Batteriesystem 4 weist in dem in Fig. 1 dargestellten schematischen Ausführungsbeispiel zwei Batteriemodule 10 auf. Die Batteriemodule 10 weisen hierbei jeweils beispielhaft vier reihengeschaltete Batteriezellen 12 auf, und sind jeweils mit einem Zellencontroller 14 ausgeführt. Der Zellencontroller 14 ist für ein Einzel-Modul- und Einzel-Zellen-Management geeignet und eingerichtet. Der Zellencontroller 14 ist also ein Zellen-Kontrollsystem oder Zellen-Steuergerät, welcher als Überwachungs- und Steuereinheit (Cell Supervision) eine Gruppe von Batteriezellen 12 überwacht und steuert. Die Batteriezellen 12 sind in den Figuren lediglich beispielhaft mit Bezugszeichen versehen.

Die Zellencontroller 14 überwachen im Zuge des Einzel-Zellen-Managements den Betriebszustand des Batteriemoduls 10 beziehungsweise der Anzahl von Batteriezellen 12. Der Betriebszustand wird hierbei insbesondere mittels einer Erfassung der jeweiligen (Batterie-)Zellenspannungen überwacht, welche eine Bestimmung relevanter Batterieparameter ermöglichen. Insbesondere wird hierbei ein jeweiliger Ladezustand (State of Charge, SOC) der Batteriezellen 12 bestimmt und überwacht. Die Zellencontroller 14 sind hierbei vorzugsweise schaltungstechnisch dazu geeignet und eingerichtet Ladungsunterschiede der Batteriezellen 12 des jeweiligen Batteriemoduls 10 zu erfassen und auszugleichen. Mit anderen Worten steuern und/oder regeln die Zellencontroller 14 den Ladungszustand der Batteriezellen 12.

Die Zellencontroller 14 der Batteriemodule 10 sind reihenschaltungstechnisch nach Art einer Daisy-Chain mittels einer Busleitung 16 miteinander signaltechnisch gekoppelt und an einen gemeinsamen Batteriemanagementcontroller 18 geführt. Der Batteriemanagementcontroller 18 ist insbesondere zum Temperaturmanagement und Betrieb des Batteriesystems 2 geeignet und eingerichtet. Der Batteriemanagementcontroller 18 erfasst beispielsweise die an den Anschlüssen 6, 8 anliegende Batteriespannung als Maß für den Betriebszustand des Batteriesystems 2 und weist weiterhin Diagnose- und Sicherheits-Funktionen für einen fehlerfreien und betriebssicheren Betrieb des Batteriesystems 2 auf. Der Batteriemanagementcontroller 18 weist weiterhin eine Kommunikationsleitung 19 zur signal- und/oder datentechnischen Kommunikation mit einer Steuereinheit des Kraftfahrzeugs 2 auf. Die Zellencontroller 14 und der Batteriemanagementcontroller 18 bilden ein nicht näher bezeichnetes Batteriemanagementsystem (BMS) des Batteriesystems 2.

Der insbesondere mit einem Mikrocontroller ausgeführte Batteriemanagementcontroller 18 ist signaltechnisch mit einer Batterietrenneinheit 20 gekoppelt. Die Batterietrenneinheit 20 ist im Bereich der Anschlüsse 6, 8 angeordnet und dient einem Zu- und Abschalten des Batteriesystems 2 an beziehungsweise von Verbrauchern. Im gezeigten Ausführungsbeispiel der Fig. 1 dient die Batterietrenneinheit 20 insbesondere dem Zu- und Abschalten des Batteriesystems 2 an den Zwischenkreis des Bordnetzes. Die Batterietrenneinheit 20 wird von dem Batteriemanagementcontroller 18 angesteuert. Der Batteriemanagementcontroller 18 stellt hierbei sicher, dass das Batteriesystem 2 zuverlässig gegen Fehlerströme und/oder Fehlerspannungen gesichert ist. Insbesondere wird hierbei ein zweipoliges Abtrennen der Batteriezellen 12 vom Zwischenkreis ermöglicht, was insbesondere hinsichtlich Wartungs- und Reparaturarbeiten des Batteriesystems 2 und/oder des Traktionsnetzes vorteilhaft ist.

Nachfolgend ist anhand der Fig. 2 der Aufbau eines Batteriemoduls 10 näher erläutert. Das Batteriemodul 10 weist eine Gruppe, also ein Paket oder einen Stapel von beispielsweise als Lithium-Ionen-Zellen ausgeführten Batteriezellen 12 auf. Die Batteriezellen 12 sind beispielsweise als Pouch-Zellen ausgeführt und benachbart aneinandergereiht und verschaltet. Die Batteriezellen 12 sind mit dem Zellencontroller 14 des Batteriemoduls 10 gekoppelt.

Der Zellencontroller 14 weist einen Analog-Digital-Wandler 22 auf, welcher mittels einer Filterschaltung 24 an die Pole oder Anschlüsse der Batteriezellen 12 geführt ist. In diesem Ausführungsbeispiel ist die Filterschaltung 24 insbesondere Teil des Zellencontrollers 14. Mit anderen Worten ist die Filterschaltung 24 in den Zellencontroller 14 integriert. Der Analog-Digital-Wandler 22 digitalisiert die erfassten Zellenspannungen der Batteriezellen 12 und übermittelt das digitalisierte Ausgangssignal an eine Auswerteelektronik 26 des Zellencontrollers 14. Die Auswerteelektronik 26 ist insbesondere als ein anwendungsspezifischer Schaltkreis (ASIC) ausgeführt und nachfolgend auch als solcher bezeichnet. Vorzugsweise ist der Analog-Digital-Wandler 22 Teil des ASIC 26.

Der ASIC 26 übermittelt die ausgewerteten Daten mittels in den Zellencontroller 14 integrierten Schnittstellen 28 über die somit gebildete Busleitung 16 an die benachbarten Zellencontroller 14 beziehungsweise an den Batteriemanagementcontroller 18.

Der Analog-Digital-Wandler 22 tastet die Zellenspannungen der Batteriezellen 12 mittels einer Abtastfrequenz fa ab und erzeugt anhand der Abtastpunkte das digitale (Mess-)Signal. Zur Einhaltung des Nyquist-Shannon-Abtasttheorems weist die Filterschaltung 24 eine Grenzfrequenz fg auf, welche kleiner oder gleich der halben Abtastfrequenz fa des Analog-Digital-Wandlers 22 ist (fg ≤ ½ fa). Die Filterschaltung 24 ist hierbei besonders vorteilhaft als ein Tiefpass ausgeführt.

Das Batteriesystem 4 erfüllt weiterhin die Anforderungen einer On-Board-Diagnose (OBD), insbesondere der sogenannten OBD2. Dies bedeutet, dass im Betrieb des Kraftfahrzeugs 2 der Betriebszustand des Batteriesystems 4, insbesondere jedes Batteriemoduls 10 oder jeder Batteriezelle 12, regelmäßig überwacht wird, und auftretende Fehler über die Kommunikationsleitung 19 an das (Kraftfahrzeug-)Steuergerät übermittelt und dort in einem Fehlerspeicher hinterlegt werden. Mit anderen Worten erfolgt periodisch oder regelmäßig eine Diagnose oder Abfrage der Betriebszustände aller Batteriemodule 10 und somit eine Fehlerprotokollierung. Die Grenzfrequenz fg der Filterschaltung hat einen direkten Einfluss auf eine für die im Zuge der OBD2 benötigten Diagnosezeitdauer td.

Im Normalbetrieb des Batteriesystems 2 werden während einer Abtastzeitdauer ta die Betriebszustände der Batteriezellen 12 mittels der Zellencontroller 14 erfasst und ausgewertet. Im Zuge der OBD2 wird der Normalbetrieb, also das seitens der Zellencontroller 14 durchgeführte Einzel-Zellen-Management, zeitweise für die Diagnosezeitdauer td unterbrochen, wobei die Betriebszustände der Batteriezellen 12, insbesondere deren zugeordneten Sensoren und Aktoren, von dem Batteriemanagementcontroller 18 überwacht und mittels der Kommunikationsleitung 19 an das (Kraftfahrzeug-)Steuergerät übermittelt werden.

Die Filterschaltung 24 ist hierbei mit einer Frequenzschaltung 30 versehen, mittels welcher die Grenzfrequenz fg der Filterschaltung 24 einstellbar oder umschaltbar, d. h. veränderbar ist. Insbesondere ist die Frequenzschaltung 24 dazu geeignet und eingerichtet die Grenzfrequenz fg der Filterschaltung 24 während der Abtastzeitdauer ta auf einen ersten Frequenzwert f1 und während der Diagnosezeitdauer td auf einen zweiten Frequenzwert f2 einzustellen (umzuschalten). Die Frequenzschaltung 24 ist hierbei insbesondere für ein reversibles Umschalten der Grenzfrequenz fg zwischen den Frequenzwerten f1 und f2 geeignet und eingerichtet.

Der Frequenzwert f1 während der Abtastzeitdauer ta ist hierbei derart gewählt, dass er das Abtasttheorem hinsichtlich des der Filterschaltung 24 nachgeschalteten Analog-Digital-Wandlers 22 erfüllt. Mit anderen Worten ist der Frequenzwert f1 vorzugsweise kleiner oder gleich der halben Abtastfrequenz fa des Analog-Digital-Wandlers 22 (fg = f1 ≤ ½ fa).

Der Frequenzwert f2 während der Diagnosezeitdauer td ist insbesondere dahingehend gewählt, dass eine möglichst kurze Diagnosezeitdauer td realisiert ist. Mit anderen Worten ist der Frequenzwert f2 insbesondere höherfrequenter als der Frequenzwert f1 (f1 < f2). Zum Umschalten zwischen den Frequenzwerten f1 und f2 wird die Frequenzschaltung 30 mit einem Steuersignal S des zugeordneten Zellencontrollers 14 angesteuert.

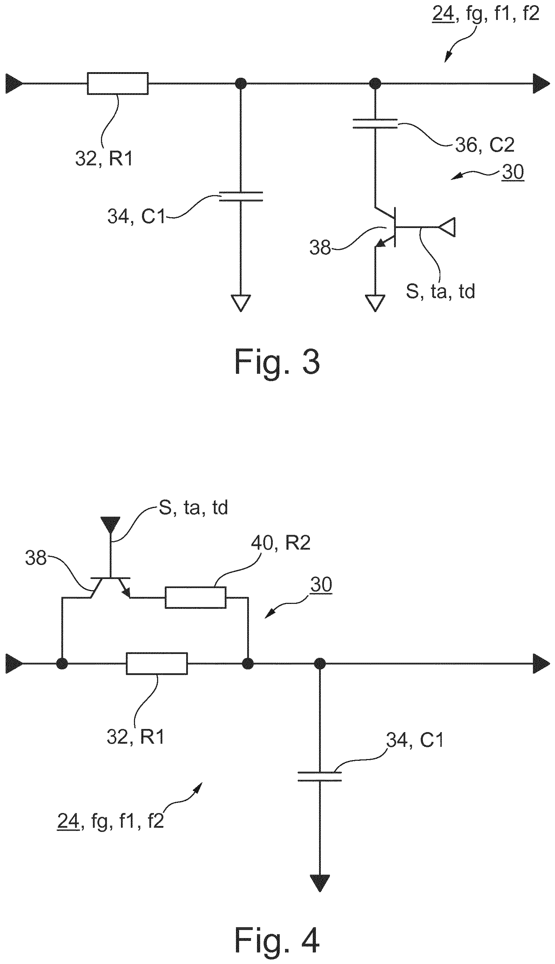

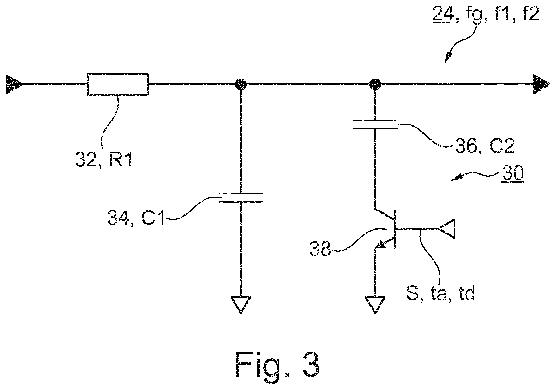

Nachfolgend sind anhand der Figuren 3 und 4 zwei Ausführungsbeispiele der Frequenzschaltung 30 näher erläutert. In den gezeigten Ausführungsbeispielen ist die Filterschaltung 24 jeweils als ein RC-Tiefpass mit einem ohmschen Widerstand 32 und mit einem Kondensator 34 als Filterelement ausgeführt. Der Widerstand 32 ist hierbei in Reihe zwischen den Batteriezellen 12 und den Analog-Digital-Wandler 22 geschaltet, wobei der Kondensator 34 parallel zu den Eingängen des Analog-Digital-Wandlers 22 geschaltet ist.

In dem Ausführungsbeispiel der Fig. 3 ist die Frequenzschaltung 30 parallel zu dem Kondensator 34 geschaltet. Die Frequenzschaltung 30 weist hierbei eine Reihenschaltung mit einem als zweites Filterelement wirkenden Kondensator 36 und mit einem mittels des Steuersignals S betätigbaren Schaltelements 38 auf. Das Schaltelement 38 ist hierbei insbesondere als ein Bipolartransistor ausgeführt, wobei das Steuersignal S an den Steuer- oder Basisanschluss geführt ist. Der Widerstand 32 weist einen Widerstandswert R1 auf. Der Kondensator 34 weist einen Kapazitätswert C1 und der Kondensator 36 weist einen Kapazitätswert C2 auf.

Bei einem geöffneten, also sperrend oder nichtleitend geschalteten Schaltelement 38 wirken lediglich der Widerstand 32 und der Kondensator 34 des RC-Tiefpasses, sodass die resultierende Grenzfrequenz fg für den Analog-Digital-Wandler 22 gleich

$$fg = f2 = \frac{1}{2\pi \, R1 \, C1}$$

ist, wobei π die Kreiszahl ist. Mit anderen Worten ist die Grenzfrequenz fg invers proportional zu dem Produkt des Widerstandswerts R1 und des Kapazitätswerts C1. Somit weist die Filterschaltung 24 eine Grenzfrequenz fg gleich dem Frequenzwert f2 auf.

Bei einem geschlossenen, also leitend geschalteten Schaltelement 38 wirkt neben dem Widerstand 32 und dem Kondensator 34 des RC-Tiefpasses zusätzlich der Kondensator 36 der Frequenzschaltung 30, wodurch sich die Grenzfrequenz fg zu

$$fg = f1 = \frac{1}{2\pi \, R1 \, (C1 + C2)}$$

ergibt. In diesem Falle ist die Grenzfrequenz fg invers proportional zu dem Produkt des Widerstandswerts R1 und der Summe der Kapazitätswerte C1 und C2. Somit ist die Grenzfrequenz fg auf den Frequenzwert f1 eingestellt.

Mit anderen Worten ist das Schaltelement 38 während der Abtastzeitdauer ta geschlossen, also mittels des Steuersignals S leitend geschaltet, sodass die Grenzfrequenz fg auf den Frequenzwert f1 erniedrigt oder reduziert wird. Während der Diagnosezeitdauer td wird das Schaltelement 38 geöffnet, also mittels des Steuersignals S elektrisch nicht-leitend oder sperrend geschaltet, sodass lediglich die erste Kapazität wirkt und die Grenzfrequenz fg der Filterschaltung 24 dem höherfrequenten Frequenzwert f2 entspricht.

In dem in Fig. 4 gezeigten, alternativen Ausführungsbeispiel ist die Frequenzschaltung 30 parallel zu dem Widerstand 32 des RC-Tiefpasses geschaltet. Die Frequenzschaltung 30 weist hierbei eine Reihenschaltung des Schaltelements 38 und eines ohmschen Widerstands 40 mit dem Widerstandswert R2 auf. In diesem Ausführungsbeispiel wirken die Widerstände 32 und 40 als parallel geschaltete Filterelemente zur Einstellung der Grenzfrequenz fg.

Bei einem geschlossenen Schaltelement 38 addieren sich die Leitwerte der ohmschen Widerstände 32 und 40. Somit ergibt sich die wirkende Grenzfrequenz fg als

$$fg = f2 = \frac{1}{2\pi \left(\frac{R1 \, R2}{R1 + R2}\right) C1},$$

was in dieser Ausführungsfrom dem höherfrequenten Frequenzwert f2 entspricht.

Bei einem geöffneten Schaltelement 38 wirkt wiederum lediglich der RC-Tiefpass, sodass sich die resultierende Grenzfrequenz fg für den Analog-Digital-Wandler 22 als

$$fg = f1 = \frac{1}{2\pi \, R1 \, C1}$$

ergibt. Dies entspricht in diesem Ausführungsbeispiel dem niederfrequenten Frequenzwert f1.

Mit anderen Worten ist das Schaltelement 38 während der Abtastzeitdauer ta geöffnet, wodurch die Grenzfrequenz fg auf den niederfrequenten Frequenzwert f1 eingestellt wird. Während der Diagnosezeitdauer td wird das Schaltelement 38 geschlossen, sodass die Grenzfrequenz fg der Filterschaltung 24 auf den höherfrequenten Frequenzwert f2 eingestellt wird.

Vorzugsweise beträgt der Unterschied zwischen den Frequenzwerten f1 und f2 mindestens eine Größenordnung.

In einer geeigneten Dimensionierung des in der Fig. 3 gezeigten Ausführungsbeispiels ist der Kapazitätswert C1 beispielsweise gleich 10 nF (Nanofarad) und der Kapazitätswert C2 gleich 470 nF. Der Widerstandswert R1 ist vorzugsweise etwa 6,8 kOhm (Kiloohm), so dass der erste Frequenzwert f1 etwa 48,8 kHz (Kilohertz) und der zweite Frequenzwert f2 etwa 2,34 kHz sind.

In dem Ausführungsbeispiel der Fig. 4 ist der Kapazitätswert C1 beispielsweise gleich 470 nF, wobei der Widerstandswert R1 auf etwa 6,8 kOhm und der Widerstandswert R2 auf etwa 150 Ohm dimensioniert sind. Somit weist der Frequenzwert f1 beispielsweise einen Wert von 49,8 kHz und der Frequenzwert f2 einen Wert von etwa 2,31 kHz auf.

Die Erfindung ist nicht auf das vorstehend beschriebene Ausführungsbeispiel beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit dem Ausführungsbeispiel beschriebenen Einzelmerkmale auch auf andere Weise miteinander kombinierbar, ohne den Gegenstand der Erfindung zu verlassen.

Bezugszeichenliste

| | |
|---|---|
| 2 | Kraftfahrzeug |
| 4 | Batteriesystem |
| 6, 8 | Anschluss |
| 10 | Batteriemodul |
| 12 | Batteriezelle |
| 14 | Zellencontroller |
| 16 | Busleitung |
| 18 | Batteriemanagementcontroller |
| 20 | Batterietrenneinheit |
| 22 | Analog-Digital-Wandler |
| 24 | Filterschaltung |
| 26 | Auswerteelektronik/ASIC |
| 28 | Schnittstelle |
| 30 | Frequenzschaltung |
| 32 | Widerstand |
| 34, 36 | Kondensator |
| 38 | Schaltelement |
| 40 | Widerstand |
| | |
| fa | Abtastfrequenz |
| fg | Grenzfrequenz |
| ta | Abtastzeitdauer |
| td | Diagnosezeitdauer |
| f1, f2 | Frequenzwert |
| S | Steuersignal |
| R1, R2 | Widerstandswert |
| C1, C2 | Kapazitätswert |

**Patentansprüche**

1. Batteriesystem (4) für ein Kraftfahrzeug (2), aufweisend mindestens ein Batteriemodul (10) mit einer Anzahl von Batteriezellen (12) und mit einem Zellencontroller (14) zur Überwachung und Einstellung des Ladungszustands der Batteriezellen (12), und einen Batteriemanagementcontroller (18), welcher mit dem oder jedem Zellencontroller (14) signaltechnisch gekoppelt ist, wobei der Zellencontroller (14) einen Analog-Digital-Wandler (22) aufweist, welcher mittels einer Filterschaltung (24) an die Batteriezellen (12) des Batteriemoduls (10) geführt ist, **gekennzeichnet durch** eine Frequenzschaltung (30) zur Einstellung einer Grenzfrequenz (fg) der Filterschaltung (24), wobei die Grenzfrequenz (fg) der Filterschaltung (24) während einer Abtastzeitdauer (ta), bei welcher der Zellencontroller (14) die Batteriezellen (12) überwacht, auf einen ersten Frequenzwert (f1) und während einer Diagnosezeitdauer (td), bei welcher der Batteriemanagementcontroller (18) die Batteriezellen (12) überwacht, auf einen zweiten Frequenzwert (f2) eingestellt ist.

2. Batteriesystem (4) nach Anspruch 1, **dadurch gekennzeichnet,** **dass** die Zellencontroller (12) mehrerer Batteriemodule (10) mittels einer Busleitung (16) nach Art eines Daisy-Chain an den Batteriemanagementcontroller (18) geführt sind.

3. Batteriesystem (4) nach Anspruch 1 oder 2, **dadurch gekennzeichnet,** **dass** die Filterschaltung (24) mittels der Frequenzschaltung (30) zwischen den Frequenzwerten (f1, f2) reversibel umschaltbar ist.

4. Batteriesystem (4) nach einem der Ansprüche 1 bis 3, **dadurch gekennzeichnet,** **dass** die Filterschaltung (24) als Tiefpass ausgeführt ist.

5. Batteriesystem (4) nach einem der Ansprüche 1 bis 4, **dadurch gekennzeichnet,** **dass** die Filterschaltung (24) einen mit den Batteriezellen (12) und mit dem Analog-Digital-Wandler (22) in Reihe geschalteten ohmschen Widerstand (32) sowie einen parallel zu den Batteriezellen (12) und dem Analog-Digital-Wandler (22) geschalteten ersten Kondensator (34) aufweist.

6. Batteriesystem (4) nach einem der Ansprüche 1 bis 5, **dadurch gekennzeichnet,** **dass** die Frequenzschaltung (30) parallel zu einem Filterelement der Filterschaltung (24), insbesondere zu dem ersten Kondensator (34), geschaltet ist.

7. Batteriesystem (4) nach einem der Ansprüche 1 bis 6,
**dadurch gekennzeichnet,**
**dass** die Frequenzschaltung (30) ein betätigbares Schaltelement (38) und einen zweiten Kondensator (36) aufweist, welcher in Reihe zu dem Schaltelement (38) geschaltet ist.

8. Kraftfahrzeug (2) mit einem Batteriesystem (4) nach einem der Ansprüche 1 bis 7.

**Claims**

1. Battery system (4) for a motor vehicle (2), having at least one battery module (10) with a number of battery cells (12) and with a cell controller (14) for monitoring and adjusting the state of charge of the battery cells (12), and a battery management controller (18), which is signal-coupled to the or each cell controller (14), wherein the cell controller (14) has an analogue-to-digital converter (22) which is connected to the battery cells (12) of the battery module (10) by means of a filter circuit (24), **characterized by** a frequency circuit (30) for adjusting a cut-off frequency (fg) of the filter circuit (24), wherein the cut-off frequency (fg) of the filter circuit (24) is adjusted to a first frequency value (f1) during a sampling period (ta) in which the cell controller (14) monitors the battery cells (12), and to a second frequency value (f2) during a diagnostic period (td) in which the battery management controller (18) monitors the battery cells (12).

2. Battery system (4) according to Claim 1, **characterized in that** the cell controllers (12) of a plurality of battery modules (10) are connected to the battery management controller (18) in the manner of a daisy chain by means of a bus line (16).

3. Battery system (4) according to Claim 1 or 2, **characterized in that** the filter circuit (24) can be reversibly switched between the frequency values (f1, f2) by means of the frequency circuit (30).

4. Battery system (4) according to one of Claims 1 to 3, **characterized in that** the filter circuit (24) is designed as a low-pass filter.

5. Battery system (4) according to one of Claims 1 to 4, **characterized in that** the filter circuit (24) has an ohmic resistor (32) which is connected in series with the battery cells (12) and with the analogue-to-digital converter (22), and a first capacitor (34) which is connected in parallel with the battery cells (12) and the analogue-to-digital converter (22) .

6. Battery system (4) according to one of Claims 1 to 5, **characterized in that** the frequency circuit (30) is connected in parallel with a filter element of the filter circuit (24), in particular with the first capacitor (34).

7. Battery system (4) according to one of Claims 1 to 6, **characterized in that** the frequency circuit (30) has an actuatable switching element (38) and a second capacitor (36), which is connected in series with the switching element (38).

8. Motor vehicle (2) with a battery system (4) according to one of Claims 1 to 7.

**Revendications**

1. Système de batterie (4) destiné à un véhicule automobile (2) et comportant au moins un module de batterie (10) pourvu d'un certain nombre d'éléments de batterie (12) et d'un contrôleur d'éléments (14) destiné à surveiller et régler l'état de charge des éléments de batterie (12), et un contrôleur de gestion de batterie (18) qui est accouplé au ou à chaque contrôleur d'éléments (14) par une technique de signal, le contrôleur d'éléments (14) comportant un convertisseur analogique-numérique (22) qui est amené aux éléments de batterie (12) du module de batterie (10) au moyen d'un circuit de filtrage (24), **caractérisé par** un circuit de fréquence (30) destiné à régler une fréquence limite (fg) du circuit de filtrage (24), la fréquence limite (fg) du circuit de filtrage (24) étant réglée, pendant une période d'échantillonnage (ta) pendant laquelle le contrôleur d'éléments (14) surveille les éléments de batterie (12), à une première valeur de fréquence (f1) et, pendant une période de diagnostic (td) pendant laquelle le contrôleur de gestion de batterie (18) surveille les éléments de batterie (12), à une deuxième valeur de fréquence (f2).

2. Système de batterie (4) selon la revendication 1, **caractérisé en ce que**
les contrôleurs d'éléments (12) de plusieurs modules de batterie (10) sont amenés au contrôleur de gestion de batterie (18) au moyen d'une ligne de bus (16) à la manière d'une guirlande.

3. Système de batterie (4) selon la revendication 1 ou 2, **caractérisé en ce que**
le circuit de filtrage (24) peut être commuté de manière réversible entre les valeurs de fréquence (f1, f2) au moyen du circuit de fréquence (30).

4. Système de batterie (4) selon l'une des revendications 1 à 3,
**caractérisé en ce que**
le circuit de filtrage (24) est conçu comme un filtre passe-bas.

5. Système de batterie (4) selon l'une des revendications 1 à 4,
   **caractérisé en ce que**
   le circuit de filtrage (24) comporte une résistance ohmique (32) montée en série avec les éléments de batterie (12) et avec le convertisseur analogique-numérique (22) et un premier condensateur (34) monté en parallèle avec les éléments de batterie (12) et le convertisseur analogique-numérique (22).

6. Système de batterie (4) selon l'une des revendications 1 à 5,
   **caractérisé en ce que**
   le circuit de fréquence (30) est monté en parallèle avec un élément de filtrage du circuit de filtrage (24), en particulier avec le premier condensateur (34).

7. Système de batterie (4) selon l'une des revendications 1 à 6,
   **caractérisé en ce que**
   le circuit de fréquence (30) comporte un élément de commutation actionnable (38) et un deuxième condensateur (36) qui est monté en série avec l'élément de commutation (38).

8. Véhicule automobile (2) comprenant un système de batterie (4) selon l'une des revendications 1 à 7.

Fig. 1

Fig. 2

24, fg, f1, f2

32, R1

36, C2

30

34, C1

38

S, ta, td

## Fig. 3

S, ta, td

38

40, R2

30

32, R1

34, C1

24, fg, f1, f2

## Fig. 4

24, fg, f1, f2

32, R1

36, C2

30

34, C1

38

S, ta, td

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012211086 A1
- DE 102012211088 A1
- DE 10143732 A1
- DE 69318787 T2
- DE 69118469 T2
- WO 2015087488 A1
- DE 102014116986 A1